# EUROPEAN PATENT SPECIFICATION

(11) **EP 3 071 958 B1**
(45) Date of publication and mention of the grant of the patent: **03.01.2018**
(21) Application number: 14815399.2
(22) Date of filing: 20.11.2014
(51) Int. Cl.: G01N 27/22, G01N 27/24, G01R 27/26

(54) **METHOD FOR ASSESSMENT OF MAINTENANCE NEED**
VERFAHREN ZUR BEURTEILUNG DES WARTUNGSBEDARFS
PROCÉDÉ D'ESTIMATION D'UN BESOIN D'ENTRETIEN

(30) Priority: 21.11.2013 FI 20136160
(43) Date of publication of application: 28.09.2016
(73) Proprietor: Outotec (Finland) Oy, 02230 Espoo (FI)
(72) Inventor: LINDGREN, Mari, FI-28430 Pori (FI)
(74) Representative: Kolster Oy Ab
(86) International application number: PCT/FI2014/050886
(87) International publication number: WO 2015/075313

(56) References cited:
- US-A- 4 814 690
- US-A1- 2003 080 744
- A.V Mamishev ET AL: "Evaluation of diffusion-driven material property profiles using three-wavelength interdigital sensor", IEEE Transactions on Dielectrics and Electrical Insulation, 1 January 2001 (2001-01-01), pages 785-798, XP055167010, New York DOI: 10.1109/94.959702 Retrieved from the Internet: URL:http://ieeexplore.ieee.org/xpls/abs_al l.jsp?arnumber=959702
- THOMAS Z M ET AL: "Sensors for measurement of moisture diffusion in power cables with oil-impregnated paper", JOURNAL OF PHYSICS: CONFERENCE SERIES, INSTITUTE OF PHYSICS PUBLISHING, BRISTOL, GB, vol. 76, no. 1, 1 July 2007 (2007-07-01), page 12006, XP020125164, ISSN: 1742-6596, DOI: 10.1088/1742-6596/76/1/012006
- GÉRALDINE VILLAIN ET AL: "Use of ultrasonic and electromagnetic NDT to evaluate durability monitoring parameters of concretes", NON DESTRUCTIVE TESTING IN CIVIL ENGINEERING, NANTES, FRANCE, 30.06-03.07 2009, 1 January 2009 (2009-01-01), XP055166970,
- Justyna Szlagowska-Spychalska ET AL: "A Novel Approach For The Eddy Current Inspection Of The Aerospace Structures Based On The Signal Modeling And Signal Processing", 18th World Conference on Nondestructive Testing, 20 April 2012 (2012-04-20), XP055167209, Retrieved from the Internet: URL:http://www.ndt.net/article/wcndt2012/p apers/270_wcndtfinal00270.pdf [retrieved on 2015-02-04]

## Description

### FIELD OF THE INVENTION

The present invention relates to a method of detecting moisture, and particularly to capacitive measurements of structures.

### BACKGROUND OF THE INVENTION

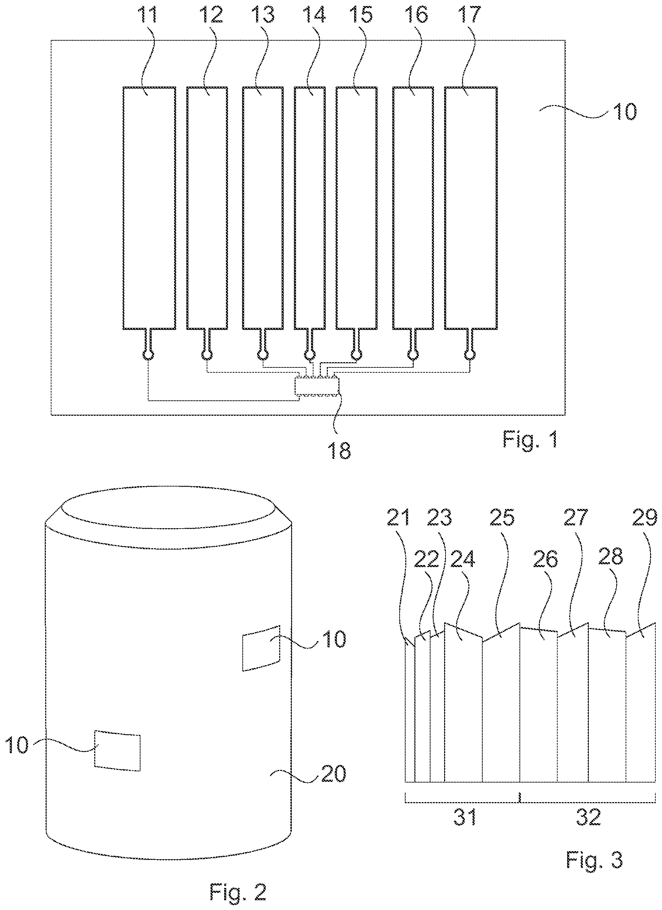

FRP (Fibre-reinforced plastic) reactors are typically employed in the leaching stage of hydrometallurgical processes. FRP materials are so called composite materials in which glass fibres give strength and vinyl ester resin (polymer) gives chemical resistance. On the surface there is a resin-rich chemical resistance layer that gives corrosion resistance and the structural layer containing glass fibres gives strength to the structure. An example of such structure is shown schematically in Figure 3. FRP materials have poor wear resistance against moving solids inside the reactor. Because of this the corrosion layer wears off and must be re-lined periodically. Maintenance must be carried out before the corrosion layer is worn away and the structural layer has become exposed to the corrosive process solution.

If the process solution enters the structural layer, the load-bearing capacity of the laminate structure may be compromised and a total failure may follow. The failure of FRP material occurs typically with little warning signs and consequences may be severe in form of human casualties, environmental damage and economic losses. On other hand, re-lining the reactors too often causes unnecessary downtime and costs. One of the problems is that there are no established methods to monitor the condition of an FRP laminate in process piping and for example in the leaching reactor type applications.

### BRIEF DESCRIPTION OF THE INVENTION

An object of the present invention is thus to provide a method so as to solve the above problems. The objects of the invention are achieved by a method which is characterized by what is stated in the independent claim. A preferred embodiment of the invention is disclosed in the dependent claim. The invention is based on the idea of measuring damage of a structure by measuring a depth into which liquids contained by the structure can penetrate the structure from inside the structure. The measuring can be conducted with a measuring device having multiple capacitive electrodes and means for measuring, for example, permittivity or admittivity of the material and means for processing the results for providing a profile representing the changes in permittivity or admittivity relative to measurement depth. The invention is effective when measuring electrical isolators, such as plastics, fibre reinforced plastics and laminates. The permittivity of water is so high relative to said materials that even a small amount of moisture within the structure can be detected.

An advantage of the method of the invention is that they enable non-invasive assessment of maintenance need. Another advantage is that the invention enables continuous monitoring for maintenance needs and separate assessment visits to sites are no longer necessary.

### BRIEF DESCRIPTION OF THE DRAWINGS

In the following the invention will be described in greater detail by means of preferred embodiments with reference to the accompanying drawings, in which
Figure 1 illustrates an exemplary layout of a measuring device according to an embodiment;
Figure 2 illustrates monitoring setup of a reactor having a fibre reinforced plastic laminate structure; and
Figure 3 illustrates an example of a fibre reinforced plastic laminate structure.

### DETAILED DESCRIPTION OF THE INVENTION

Figure 1 is illustrates a device 10 according to an embodiment of the invention. The device 10 has a simple structure of seven capacitive electrodes 11-17 and control electronics 18. The number of capacitive electrodes can be virtually anything from three electrodes to tens or even hundreds of electrodes. The number of capacitive electrodes is preferably from 3 to 15 and more preferably from 5 to 9. The number of capacitive electrodes affects the number of possible measurements and thus higher number of capacitive electrodes means increased complexity but also increased resolution.

The capacitive electrodes are preferably of a different size compared to each other. Variable sizes increase measurement range and resolution of the device and reduces the possibility of a systematic error. According to an embodiment of the invention, one or more of the capacitive electrodes is of a different size compared to the other capacitive electrodes. According to an embodiment of the invention, each of the capacitive electrodes is of a different size compared to the other capacitive electrodes. According to an embodiment of the invention, all the capacitive electrodes have equal size.

The control electronics 18 is shown as a single electronic circuit in Fig. 1 but the control electronics can also be divided into several electronic circuits or even to an external device having means for connecting to the measuring device 10. The control electronics preferably comprises memory means for storing measurement results of the capacitive electrodes, and processing means for processing the stored results into a desired format. The control electronics may be realized for example with a CPU and a volatile or a non-volatile memory and a computer program executable with said CPU.

Figure 2 illustrates a monitoring setup of a reactor having a fibre reinforced plastic laminate structure. Two similar measuring devices 10 have been arranged against an outer surface of the reactor. This exemplary monitoring setup comprises two measuring devices but according to an embodiment of the invention, the number of measuring devices is between one and ten. Preferably the number of measuring devices 10 is evaluated case by case depending on, for example, the use of the reactor, size of the reactor, contents of the reactor, etc.

Figure 3 illustrates an example of a fibre reinforced plastic laminate structure. The structure comprises a chemical resistance liner 31 which is on the inner surface of a reactor and a structural laminate 32 which is on the outer surface of the reactor. Both the chemical resistance layer 31 and the structural layer 32 consist of multiple different layers and a simplified example is illustrated here in Figure 3 which illustrates a typical fibre reinforced plastic (FRP) design for chemical resistant application. The chemical resistance liner 31 consists of pure resin layer 21, surfacing veil layers 22, 23 and at least two chopped glass strand mat layers 24, 25. The structural laminate 32 consists of filament winding or alternate layers of chopped strand mat 26, 28 and woven roving 27, 29.

Moving particles inside the reactor or inside process piping erode the chemical resistance liner and corrosive process solution, such as dilute sulphuric acid, damages the structural laminate when the erosion has breached the chemical resistance liner. The erosion is a slow process and it has been found possible to detect the erosion of a chemical resistance liner before it is breached and process solution has access to the structural laminate. The layers under the first resin layers of the chemical resistance liner can absorb the process solution and become moist. Even a relatively small amount of moisture changes the permittivity of the material significantly. For example, a 0,5 % water content can increase relative permittivity by 10 % which can be detected with capacitive measurements outside the reactor.

A damaged chemical resistance liner of an FRP reactor can be detected and the damage can be measured with a measuring device according to an embodiment of the invention. The measuring device comprises at least three capacitive electrodes and measuring means for measuring capacitance between the capacitive electrodes. The number of capacitive electrodes is preferably from 3 to 15 and more preferably from 5 to 9 which in most cases ensures sufficient measurement resolution. The electrodes are preferably substantially planar and arranged to a plane. Measurement depth can be defined to be the distance from said plane. In an embodiment of the invention, planar or substantially planar electrodes are arranged to a surface having a radius of curvature in the magnitude of radius of curvature of typical process piping or an FRP reactor.

Means for measuring capacitance between two electrodes is well known from the prior art. Preferably the measuring means are adapted to measure capacitance between each possible electrode pairs. By increasing the number of capacitive electrodes, the number of electrode pairs that can be formed also increases which in turn increases the number of capacitance measurements needed and therefore increases complexity but also increases resolution.

The measuring device also comprises memory means for storing results of the capacitance measurements. Depending on the purpose, the memory means may comprise volatile or non-volatile memory for storing the results. The measurement data may also be transmitted and stored into a server for long term storage. The memory means are connected to processing means for processing the stored results of the capacitance measurements. The result data is processed for providing a profile representing an electric property relative to measurement depth. According to an embodiment, the electric property is permittivity or relative permittivity. According to an embodiment, the electric property is admittivity. The profile provides information which is easy to interpret at a glance but also gives detailed information about the state of the measured structure.

Permittivity can be calculated when capacitance, voltage, areas of the electrodes and material layers are known. Preferably the capacitive electrodes are substantially planar. In case of about dozen layers in the structure to be measured, it might be more convenient to calibrate and adjust the output of the processing means by measuring well-known structures and adjusting the output to match the profile of the measured structure.

By increasing the number of capacitive electrodes it is possible to increase depth resolution of the permittivity profile. In a typical monitoring setup the measuring device is arranged against the outer surface of a FRP reactor so any initial damages in the structure would be seen as changes furthest away from the measuring device, i.e. on the inner surface of the reactor. The electric field invoked by the capacitance measurements will go through a path of least resistance. The closer the electrodes are, the less the electric field penetrates to the measured material. Thus the greatest difference between dry and moist inner surface should be seen in capacitance between electrodes that are the furthest apart. Similarly, the greatest difference between dry and moist outer surface should be seen in capacitance between adjacent electrodes. A sufficient amount of electrodes can be determined depending on the resolution needed and the depth of the structure to be measured.

At least three electrodes are needed for a permittivity (or admittivity) profile that has depth resolution. The permittivity profile can be calculated from results of capacitance measurements between each combination of capacitive electrode pairs. Obviously the best results can be achieved by measuring the capacitance of all possible combinations of capacitive electrode pairs and processing the data but a smaller amount of combinations can be almost as effective. In an embodiment of the invention, only a part of all the possible combinations is measured. In an embodiment, all the possible combinations are measured every now and then but monitoring is performed by measuring only a part of all the possible combinations.

In an embodiment of the invention the measuring device transmits the permittivity profile to a predetermined receiver, for example to a server, a workstation or to a person in charge of the monitored reactor. In an embodiment certain trigger values are set into the measuring device and the measuring device transmits an alert to a predetermined receiver once a trigger value is crossed.

An aspect of the invention is a method of assessing maintenance need of a structure containing liquid chemicals. The structure can be for example a pipe in process piping, an FRP reactor or a container and the chemical can be for example dilute sulphuric acid. The method comprises a step of measuring at least one electric property of the structure from outside of the structure. The measurement is a non-invasive capacitive measurement. In an embodiment of the invention, the measurement can be performed with an electrical capacitance tomography (ECT) device. In an embodiment the measurement can be performed with the measuring device described within this document. The measured electric property can be for example permittivity, relative permittivity or admittivity.

The method further comprises a step of detecting a presence of moisture within the structure based on the measured electric property. For example permittivity increases significantly when an insulator, such as plastic or FRP material, moistens. Therefore an increase in permittivity of a stabile material must be caused by moistening. The moistening of the material is not possible if the innermost resin layer is intact so the increase in permittivity within the depth of the structure must mean that the innermost resin layer has been damaged and breached. Preferably the measurement data is processed for providing a permittivity and/or admittivity profile which reveals the depth of the moistened structure.

The method further comprises a step of triggering an alarm event if the presence of moisture within the structure is detected at certain depth. Detected moisture at or near the surface of the structure may not be a reason for triggering the alarm event. However, moisture that has penetrated deeper into the structure than e.g. the thickness of the resin layer could be a reason to trigger the alarm event. In an embodiment of the invention the permittivity profile is transmitted to a predetermined receiver, for example to a server, a workstation or to a person in charge of the monitored reactor. In an embodiment certain trigger values are set and an alert is transmitted to a predetermined receiver once a trigger value is crossed.

It will be obvious to a person skilled in the art that, as the technology advances, the inventive concept can be implemented in various ways. The invention and its embodiments are not limited to the examples described above but may vary within the scope of the claims.

## Claims

1. A method of measuring damage of a structure containing liquid chemicals, wherein the method comprises steps of:
measuring capacitance between at least three capacitive electrodes of a measuring device arranged against the outer surface of the structure;
storing results of the capacitance measurements;
processing the stored results of the capacitance measurements for providing a profile representing permittivity relative to measurement depth;
detecting a presence of moisture within the structure based on the measurements; and
triggering an alarm event if the presence of moisture within the structure is detected at certain depth.

2. A method according to claim 1, **characterized in that** the structure is a fibre-reinforced plastic structure.

## Patentansprüche

1. Verfahren zur Messung der Beschädigung einer Struktur, die flüssige Chemikalien enthält, wobei das Verfahren die Schritte aufweist:
Messen einer Kapazität zwischen mindestens drei kapazitiven Elektroden einer Messvorrichtung, die gegen die Außenfläche der Struktur angeordnet ist;
Speichern von Ergebnissen der Kapazitätsmessungen;
Verarbeiten der gespeicherten Ergebnisse der Kapazitätsmessungen zur Bereitstellung eines Profils, das die Permittivität relativ zu einer Messtiefe darstellt;
Erfassen eines Vorhandenseins von Feuchtigkeit innerhalb der Struktur basierend auf den Messungen; und
Auslösen eines Alarmereignisses, wenn das Vorhandensein von Feuchtigkeit innerhalb der Struktur in einer bestimmten Tiefe erfasst wird.

2. Verfahren nach Anspruch 1, **dadurch gekennzeichnet, dass** die Struktur eine faserverstärkte Kunststoffstruktur ist.

## Revendications

1. Procédé de mesure de l'endommagement d'une structure contenant des produits chimiques liquides, dans lequel le procédé comprend les étapes consistant à :
mesurer la capacité entre au moins trois électrodes capacitives d'un dispositif de mesure agencé contre la surface externe de la structure;
stocker les résultats des mesures de capacité ;
traiter les résultats stockés des mesures de capacité pour fournir un profil représentant la permittivité par rapport à la profondeur de mesure ;
détecter une présence d'humidité dans la structure sur la base des mesures ; et
déclencher un événement d'alarme si la présence d'humidité dans la structure est détectée à une certaine profondeur.

2. Procédé selon la revendication 1, **caractérisé en ce que** la structure est une structure de matière plastique renforcée par des fibres.
